## Europäisches Patentamt
## European Patent Office
## Office européen des brevets

(11) Veröffentlichungsnummer: **0 364 760**
**A1**

(12)
# EUROPÄISCHE PATENTANMELDUNG

(21) Anmeldenummer: **89117482.3**

(51) Int. Cl.⁵: **H01L 29/91**

(22) Anmeldetag: **21.09.89**

(30) Priorität: **27.09.88 DE 3832732**

(43) Veröffentlichungstag der Anmeldung:
**25.04.90 Patentblatt 90/17**

(84) Benannte Vertragsstaaten:
**DE FR GB IT**

(71) Anmelder: **Asea Brown Boveri**
**Aktiengesellschaft**
**Kallstadter Strasse 1**
**D-6800 Mannheim 31(DE)**

(72) Erfinder: **Kelberlau, Ulrich, Dr.**
**Planckstrasse 35**
**D-6840 Lampertheim(DE)**
Erfinder: **Leifels, Joachim**
**Feldbergstrasse 27**
**D-6800 Mannheim(DE)**
Erfinder: **Langer, Kurt, Dr.**
**Kiefernweg 8**
**D-6908 Walldorf(DE)**

(74) Vertreter: **Rupprecht, Klaus, Dipl.-Ing. et al**
**c/o Asea Brown Boveri Aktiengesellschaft**
**Zentralbereich Patente Postfach 100351**
**D-6800 Mannheim 1(DE)**

(54) **Leistungshalbleiterdiode.**

(57) Bei einer isolationsdiffundierten bzw. einer mit Feldringen abgeschlossenen Leistungshalbleiterdiode ist die Aufgabe gestellt, die Eigenschaften hoher Sperrspannung, Avalanche-Festigkeit, schnelles und weiches Abschalten zu kombinieren und eine mit geringem technischem Aufwand herstellbare Ausführung anzugeben.

Diese Aufgabe wird bei einer isolationsdiffundierten Diode dadurch gelöst, daß der pn-Übergang (10) nicht in einem Passivierungsgraben, sondern direkt an einer ersten Hauptfläche (3) der Diode austritt und dort planar mit einer Passivierungsschicht (11) abgedeckt ist und außerdem im mittleren Bereich der Diode ein steiles Dotierungsprofil mit einem großen Gradienten der Dotierstoffkonzentration in der Nähe des pn-Übergangs vorgesehen ist.

Bei einer Diode mit Feldringen wird diese Aufgabe dadurch gelöst, daß sowohl der Randbereich (29) des Hauptübergangs als auch Feldringe (28) in einem gesonderten Diffusionsprozeß hergestellt werden, wodurch ein vom aktiven Teil des Bauelements abweichendes Dotierungsprofil eingestellt werden kann.

Fig 2

Fig 6

## Leistungshalbleiterdiode

Die Erfindung bezieht sich auf eine Leistungshalbleiterdiode nach dem Oberbegriff des Anspruchs 1 sowie des nebengeordneten Anspruchs 2.

Der erfindungsgemäßen Leistungshalbleiterdiode liegt die Anforderung zugrunde, eine einfach herzustellende Diode mit schnellem und weichem Abschaltverhalten zu schaffen, die außerdem eine hohe Sperrspannung und hohe Avalanche-Festigkeit aufweist. Aus der Literatur sind zwar Lösungsmöglichkeiten für jede der genannten Anforderungen bekannt, jedoch sind bei bekannten Dioden nicht alle Anforderungen in gleicher Weise zufriedenstellend erfüllt, sondern jeweils nur ein Teil davon.

Die Forderung nach hoher Sperrspannung bedeutet, daß die Diode 100% der theoretisch möglichen Volumendurchbruchspannung erreichen soll. Die Diode muß dazu mit einem geeigneten Randabschluß versehen sein. Aus Ghandhi, J.-K., Semiconductor Power Devices, Verlag Wiley and Sons, New York, 1977, Kap. 2 sind eine Reihe von Techniken und Gestaltungsmöglichkeiten für Randabschlüsse bekannt. Dazu zählt der als Moat bekannte Passivierungsgraben. Der Passivierungsgraben macht ein tiefes Dotierungsprofil mit flachem Gradienten notwendig, das im Hinblick auf das Abschaltverhalten nachteilig ist. Mit einer weiterhin bekannten Randanschrägung mit positivem Winkel läßt sich zwar eine Sperrspannung von 100% der Volumendurchbruchspannung erreichen, dazu ist aber ein nachteiliges Zerteilen des wafers mittels Sandstrahlen oder ein sogenanntes "Durchätzen" erforderlich.

Von den genannten Passivierungssystemen liefert nur ein Passivierungssystem mit positivem Winkel eine hohe Avalanche-Festigkeit, also einen hohen zulässigen Sperrstrom bei Abbruchspannung.

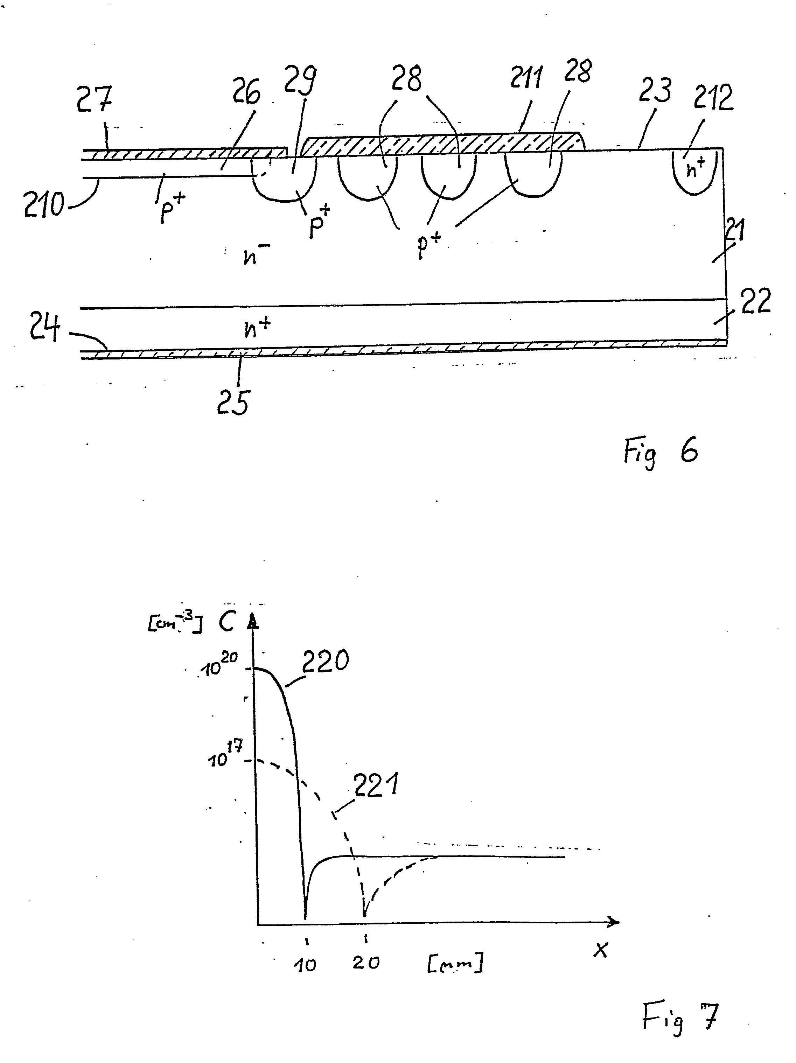

Bekannt sind auch Dioden mit einem planaren Randabschluß, der durch ein System von feldbegrenzenden Ringen mit einer Passivierungsschicht gebildet wird, beispielsweise aus Proceedings of the IEEE Vol. 55, Nr. 8, Aug. 1967, Seite 1409 bis 1414, insbesondere Fig. 5. Im Vergleich zu anderen Lösungsmöglichkeiten für den Randabschluß, bei denen eine Randkonturierung durch Gräben oder Anschrägungen vorgesehen sind, bieten planare Randabschlüsse prozeßtechnische Vorteile. Je nach Anzahl und Anordnung der Feldringe kann eine Sperrspannung realisiert werden, die nahe an die theoretisch mögliche Sperrspannung herankommt, die durch die Volumendurchbruchspannung bestimmt ist.

Die Feldringe, die auch als Guard-Ringe bezeichnet werden, umschließen als konzentrische Ringe, die in einem Abstand zueinander angeordnet sind, die aktive Fläche des Halbleiterbauelements. Solche Feldringe werden nach bekannten Verfahren gleichzeitig mit der p-leitenden Schicht des aktiven Teils der Diode hergestellt, was zur Folge hat, daß die Ringe das gleiche Dotierungsprofil wie der sperrende pn-Übergang aufweisen. Kennzeichnend für diese Art des Randabschlusses ist auch, daß die höchste Feldstärke im Randbereich auftritt, d.h. das Feldmaximum liegt entweder an der Randkrümmung des sperrenden pn-Übergangs oder an einem der Guardringe.

Der Platzbedarf hängt von der Anzahl der Ringe ab, die wiederum abhängt von der verlangten Sperrspannung. Die notwendige Anzahl der Ringe ist somit auch stark abhängig vom Dotierungsprofil des sperrenden pn-Übergangs. Das bedeutet, daß in Fällen, in denen aus Gründen, die andere Eigenschaften des Bauelements betreffen, eine geringe Tiefe des sperrenden Übergangs, beispielsweise von 5 bis 10 μm gefordert wird, eine große Zahl von Ringen, ggf. mehr als 10, mit entsprechendem Platzbedarf erforderlich ist.

Weiterhin ist beispielsweise aus der DE-AS 28 12 658 ein Verfahren zur Isolationsdiffusion bekannt, das auch mit Trenndiffusionsverfahren bezeichnet wird. Die Isolationsdiffusion hat zwar als solche keine Funktion als Randabschluß, verringert aber die Probleme des Randabschlusses, da die pn-Übergangsfläche nicht mehr am Bauelementerand austritt, sondern quasi umgelenkt wird zu der der p-Zone gegenüberliegenden Hauptfläche. Mit isolationsdiffundierten Dioden lassen sich Sperrspannungen erreichen, die 100 Prozent der Volumendurchbruchspannungen entsprechen. Die Feldstärke im gekrümmten Bereich der Isolationsdiffusion und am Austritt des pn-Übergangs in einem Passivierungsgraben ist beim isolationsdiffundierten Chip nämlich niedriger als die Feldstärke am ebenen pn-Übergang im Volumen des Chips.

Isolationsdiffundierte Dioden sind in IEEE Transactions on Electron Devices, Vol. ED-27, No. 1, January 1980, "Analysis of a Junction Termination Structure for Ideal Breakdown Voltage in p-n Junction Devices" von T. Tanaka, Y. Mochizuki und M. Okamura, Seite 261 bis 265 dargestellt, wobei die pn-Übergangsfläche in einem Passivierungsgraben endet. In Fig. 10 der genannten Druckschrift ist eine solche Diode dargestellt und außerdem gezeigt, wie die Feldstärke am Austritt des pn-Übergangs von der Tiefe des Grabens abhangt. Durch Optimierung der Grabentiefe kann die Feldstärke minimiert werden.

Ein schnelles Abschalten kann durch Verringerung der Trägerlebensdauer erreicht werden, beispielsweise durch Gold- oder Platindiffusion oder eine $e^-$- oder $H^+$-Bestrahlung.

Ein weiches Abschaltverhalten, auch soft-recovery genannt, kann durch axial inhomogene Trägerlebensdauer, z.B. mit Hilfe von $H^+$-Bestrahlung erreicht werden, wobei die Trägerlebensdauer so eingestellt wird, daß die Ladungsträgerrekombination in der Nähe des pn-Übergangs besonders schnell erfolgt.

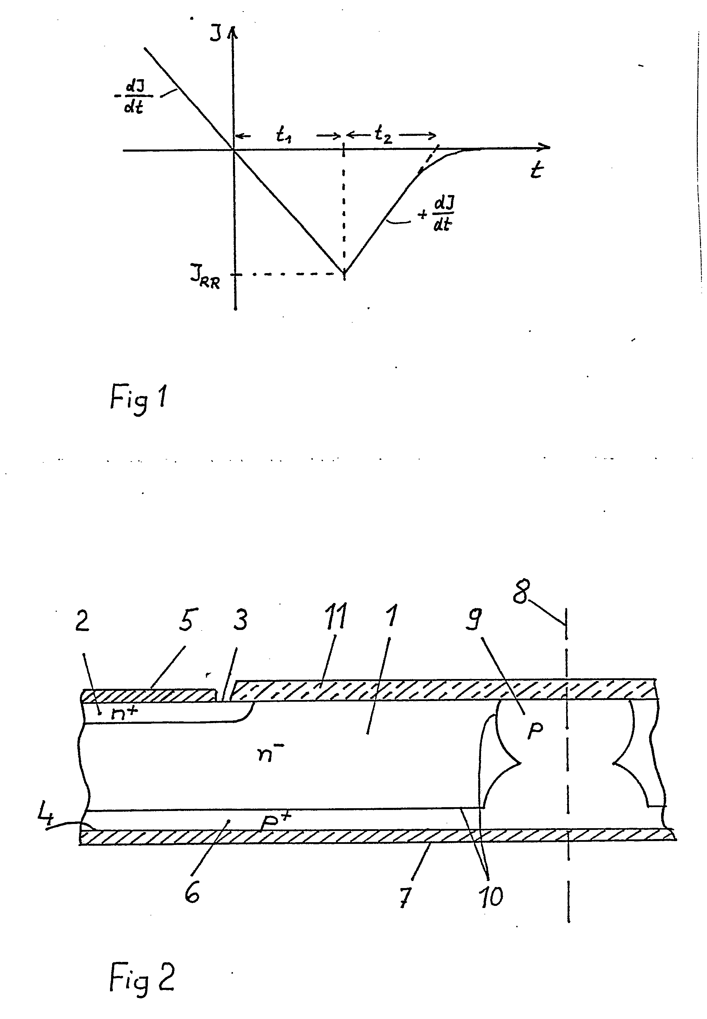

Das Abschaltverhalten einer Diode wird anhand von Fig. 1 erläutert.

In Fig. 1 ist der Stromverlauf beim Abschalten einer Diode dargestellt. In der Ordinate ist der Diodenstrom 1 aufgetragen, in der Abszisse die Zeit t. Der Strom 1 nimmt beim Abschalten mit einer negativen Änderungsgeschwindigkeit -dl/dt ab und wird in einem ersten Zeitabschnitt $t_1$ negativ, bis eine Rückstromspitze $I_{RR}$ erreicht ist. Danach nimmt der negative Strom in einem zweiten Zeitabschnitt $t_2$ mit einer positiven Änderungsgeschwindigkeit dl/dt ab bis er zu Null wird.

Um ein schnelles Abschalten zu erreichen, soll der erste Zeitabschnitt $t_1$ und damit auch die Rückstromspitze $I_{RR}$ klein sein. Um weiches Abschalten zu erreichen, soll der zweite Zeitabschnitt $t_2$ und somit das Verhaltnis $t_2 : t_1$ groß sein. Damit wird erreicht, daß in einer Schaltungsinduktivität nur eine geringe Überspannung induziert wird.

Ausgehend von dem genannten Stand der Technik liegt der Erfindung die Aufgabe zugrunde, eine verbesserte Diode anzugeben, die die eingangs genannten Anforderungen erfüllt, also schnell und weich abschaltet, eine hohe Sperrspannung und Avalanche-Festigkeit besitzt und mit geringem technischem Aufwand herstellbar ist.

Diese Aufgabe wird bei einer Diode nach einer ersten Lösungsvariante gemäß dem Oberbegriff des Anspruchs 1 durch dessen kennzeichnende Merkmale gelöst. Eine zweite Lösungsvariante ist im nebengeordneten Anspruch 2 angegeben. Vorteilhafte Ausgestaltungen sind in Unteransprüchen angegeben.

Mit der Erfindung wird bei beiden Lösungsvarianten eine Kombination von Maßnahmen vorgeschlagen, die sich in vorteilhafter Weise ergänzen und keinen nachteiligen Einfluß auf eine der geforderten Eigenschaften haben.

Die erste Lösungsvariante geht von einer bekannten Diode mit einem durch Isolationsdiffusion hergestellten Rand aus, wobei die erfindungsgemäße Merkmalkombination darin besteht, daß für den aktiven Teil der Diode - im Hinblick auf das gewünschte Abschaltverhalten - ein steiles Dotierungsprofil mit großem Konzentrationsgradienten am pn-Übergang gewählt wird und die Austrittsstelle des pn-Übergangs planar mit einer Passivierungsschicht abgedeckt wird.

Die zweite Lösungsvariante geht von einer bekannten Diode mit einem Randabschluß durch Feldringe aus, wobei im aktiven Teil ein steiles Dotierungsprofil vorgesehen ist, wie bei der ersten Lösungsvariante, und das dadurch verstärkte Randproblem durch - in einem gesonderten Diffusionsprozeß hergestellte - Schutzringe mit einem flacheren Dotierungsprofil gelöst ist.

Die Erfindung wird anhand der Zeichnung nachstehend erläutert.

Es zeigen:

Fig. 1 den Stromverlauf beim Abschalten einer Diode,

Fig. 2 einen Querschnitt durch den Randbereich einer erfindungsgemäßen Diode mit isolationsdiffundiertem Rand,

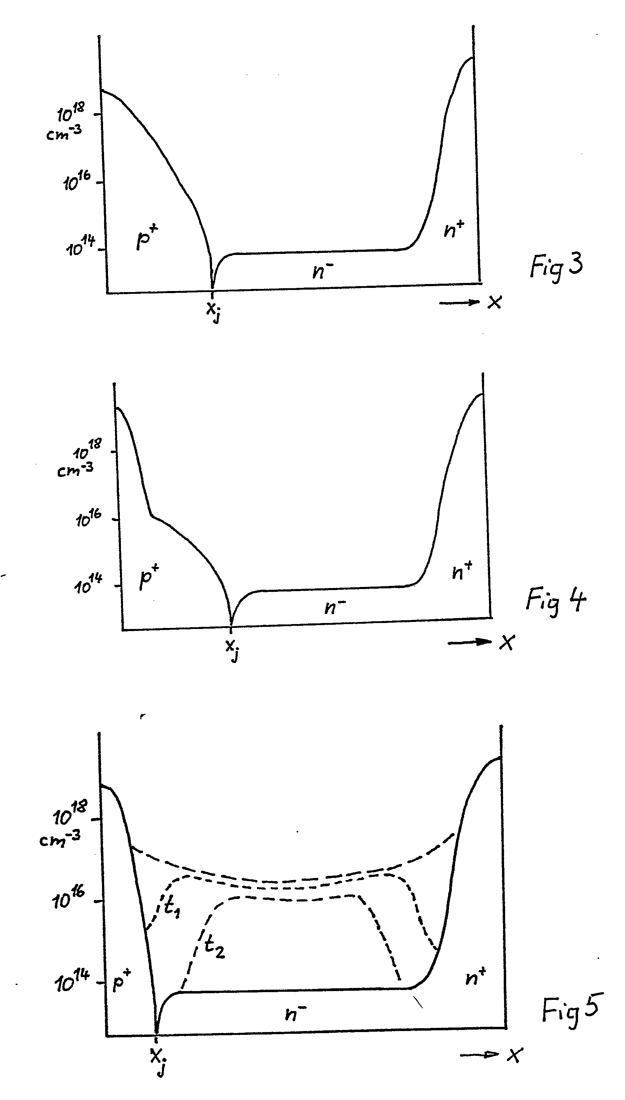

Fig. 3, 4 Dotierungsprofile herkömmlicher Dioden mit flachen Konzentrationsgradienten am pn-Übergang,

Fig. 5 das Dotierungsprofil einer erfindungsgemäßen Diode und Ladungsträgerkonzentrationen vor und während des Abschaltvorgangs,

Fig. 6 einen Querschnitt durch den Randbereich einer erfindungsgemäßen Diode mit Feldringen,

Fig. 7 Dotierungsprofile des Hauptübergangs im Volumen und am Rand und einer Diode nach Fig. 6,

Fig. 8 das Ergebnis einer Rechnersimulation zur Feldstärkeverteilung im Randbereich der in Fig. 6 dargestellten Diode.

In Fig. 2 ist ein Querschnitt durch den Randbereich einer erfindungsgemäßen Silizium-Leistungshalbleiterdiode dargestellt. Die Diode besteht aus einem n-dotierten Substrat 1 mit einer zweiten Hauptfläche 3 und einer ersten Hauptfläche 4. Die zweite Hauptfläche 3 ist in einem Randbereich der Diode die Oberfläche der n-leiten den Schicht, also des n-dotierten Substrats 1, und in einem großen mittleren Bereich die Oberfläche eines Kathodenbereichs 2 mit verstärkter n-Dotierung. Über diesem mit $n^+$ bezeichneten Kathodenbereich 2 ist eine Kathodenmetallisierung 5 angeordnet.

Die erste Hauptfläche 4 ist die Oberfläche einer mit $p^+$ bezeichneten p-leitenden Schicht 6, auf der eine Anodenmetallisierung 7 aufgebracht ist. Die Herstellung von Dioden der dargestellten Art erfolgt regelmäßig so, daß eine größere Siliziumscheibe verwendet wird und gleichzeitig mehrere Dioden hergestellt werden. Eine eingezeichnete Trennlinie 8 gibt die Stelle an, an der die Siliziumscheibe getrennt wird zur Herstellung einzelner Diodenchips. Die Trennlinie 8 führt mitten durch eine durch Isolationsdiffusion hergestellte p-dotierte Randzone 9, die nach der Teilung der Siliziumscheibe den Diodenrand bildet. Ein durch die aneinandergrenzenden n-und p-Schichten gebildeter pn-Übergang 10 tritt somit nicht am Chiprand an die Oberfläche, sondern an der zweiten Hauptfläche 3. Die Austrittsstelle des pn-Übergangs 10 ist durch eine Passivierungsschicht 11, z.B. aus Passivierungsglas, abgedeckt.

Es wurde erkannt, daß bei isolationsdiffundierten Dioden auf einen Passivierungsgraben verzichtet werden kann und trotzdem eine Sperrspannung in Höhe von 100 Prozent der Volumendurchbruchsspannung erreicht wird. Die Feldstärke am Ort des Austritts des sperrenden pn-Übergangs aus der Oberfläche ist zwar etwas höher als beim Austritt in einem Graben, jedoch deutlich niedriger als im Volumen und ohne weiteres mit bekannten bei nicht-isolationsdiffundierten Bauelementen benutzten Passivierungstechniken beherrschbar. Geeignet ist z.B. eine Passivierung mit Passivierungsglas oder einer Schichtenfolge aus z.B. Siliziumoxid, Phosphor-Silika-Glas und Siliziumnitrid, die nach einem CVD-Verfahren aufgebracht werden kann. Die vorgeschlagene Vermeidung des bisher bei solchen Leistungshalbleiterdioden für erforderlich gehaltenen Passivierungsgrabens bedeutet eine erhebliche Vereinfachung der Herstellung, da einige Schritte zur Maskierung und Ätzung entfallen und Qualitätsprobleme durch mangelhafte Kantenbedeckung eines Grabens mit der Passivierungsschicht nicht auftreten können.

Die in Fig. 2 dargestellte Diode hat auch eine hohe Avalanche-Festigkeit, weil die maximale Feldstärke am ebenen pn-Übergang auftritt, also auf der gesamten Chipfläche außer dem Passivierungsrand. Der Sperrstrom und damit die Verlustleistung wird somit homogen auf die gesamte Fläche verteilt.

Um außerdem den Anforderungen hinsichtlich des Abschaltverhaltens zu entsprechen, wurde ein steiles Dotierungsprofil mit großem Konzentrationsgradienten am $p^+$n-Übergang gewählt. Wegen der gewählten Art des Randabschlusses, nämlich des planaren Randabschlusses der isolationsdiffundierten Diode, treten auch bei steilem Dotierungsprofil keine Passivierungsprobleme auf.

Die Bedeutung eines steilen Dotierungsprofils für das Abschaltverhalten wird nachstehend erläutert.

Durch Computersimulation wurde festgestellt, daß der Abschaltvorgang wie folgt verstanden werden kann: Solange ein hoher Durchlaßstrom fließt, also vor dem Abschalten, ist die Mittelzone der Diode mit Ladungsträgern (Elektronen und Löcher) überschwemmt. Das heißt, sowohl im n- als auch im p-leitenden Gebiet ist die Ladungsträgerkonzentration größer alß $10^{16} cm^{-3}$. Beim Abschalten werden im Zeitraum $t_1$, während dem der Strom negativ wird, Ladungsträger von den hochdotierten $n^+$- und $p^+$-Randzonen her aus der Mittelzone abgezogen. Dabei bleibt die Ladungsträgerdichte im mittleren Teil der $n^-$-Zone zunächst annähernd unverändert hoch, während sie in der Nähe der $n^+$- und $p^+$-Randzonen stark abgesenkt wird, d.h. unter $5 \cdot 10^{15} cm^{-3}$. Mit fortschreitender Zeit dehnen sich die von Ladungsträgern freigeräumten Randbereiche zur Mitte hin aus. Der Zeitraum $t_1$ endet, sobald das gesamte p-dotierte Gebiet, das vor dem Abschaltvorgang mit Ladungsträgern überschwemmt war, bis zum pn-Übergang freigeräumt ist.

Sobald der pn-Übergang von Überschuß-Ladungsträgern befreit ist, baut sich eine Raumladungszone auf und die Diode kann eine Sperrspannung aufnehmen. Der Strom, der während des Zeitabschnittes $t_2$ noch fließt, wird dadurch verursacht, daß Löcher aus dem noch weiterhin überschwemmten mittleren Bereich der $n^-$-Zone aufgrund des Konzentrationsgradienten in die Raumladungszone diffundieren und so einen Stromfluß bewirken.

Der Zeitabschnitt $t_1$ wird also umso kleiner, je kleiner der Abstand zwischen hochdotiertem $p^+$-Gebiet (Dotierung = $10^{16}$ bis $10^{18} cm^{-3}$ und dem pn-Übergang gewählt wird.

Der Stromfluß während des Zeitabschnitts $t_2$ wird umso größer, je mehr Ladungsträger in der $n^-$-Zone noch zurückbleiben nachdem die Diode Sperrspannung aufnimmt.

Um ein weiches Abschalten zu erreichen, wird vorgeschlagen, das axiale Dotierungsprofil einer Diode wie folgt zu optimieren:

Der Gradient der Dotierungskonzentration zwischen dem Bereich des $p^+$-Gebiets mit einer Dotierstoffkonzentration von $10^{16}$ bis $10^{18} cm^{-3}$ und dem pn-Übergang muß möglichst groß sein. In der nachstehenden Exponentialfunktion, die das Diffusionsprofil in der Nähe des pn-Übergangs näherungsweise beschreibt, soll der Parameter Lambda, der die Steilheit des Profils beschreibt, möglichst im Bereich 0,2 bis $4 \mu m$ liegen:

$$N_x = N_0((exp[- (x - x_j)/Lambda] - 1))$$

wobei bedeutet

$N_x$ = Dotierstoffkonzentration am Ort x,

$N_0$ = Dotierstoffkonzentration in der $n^-$-Zone,

x = Ortskoordinate, gemessen ab der ersten Hauptfläche,

$x_j$ = pn-Übergang

Lambda = Parameter, der die Steilheit beschreibt und im Bereich von 0,2 bis $4 \mu m$ liegt.

Die Trägerlebensdauer wird durch eines der bekannten Verfahren, z.b. Golddiffusion, erniedrigt.

Ein Ausführungsbeispiel zur zweiten Lösungsvariante, also einer Diode mit einem Randabschluß durch Feldringe ist in Fig. 6 dargestellt.

Fig. 6 zeigt einen Querschnitt durch den Randbereich einer Diode. Die Diode weist übliche Schichten eines n-leitenden ersten Leitungstyps und eines p-leitenden zweiten Leitungstyps auf. Sie besteht aus einem schwachdotierten Substrat des ersten Leitungstyps, also einem $n^-$-Substrat 21, das kathodenseitig verstärkt dotiert ist, zur Bildung einer $n^+$-Schicht 22, die eine Kathodenmetallisierung 25 trägt. Die Oberfläche der $n^+$-Schicht 22 ist als zweite Hauptfläche 24 bezeichnet. Als erste Hauptfläche 23 ist die anodenseitige Oberfläche bezeichnet. In die Hauptfläche 23 ist eine $p^+$-leitende Schicht 26 diffundiert, auf die eine Anodenmetallisierung 27 aufgebracht ist. Die $p^+$-leitende Schicht bildet mit der $n^-$-Schicht 21 in üblicher Weise einen sperrenden pn-Übergang 210 als Hauptübergang. Im Hinblick auf ein schnelles Schalten der Diode ist nur eine geringe Eindringtiefe der $p^+$-Schicht 26 von etwa 5 bis 10 $\mu$m vorgesehen und eine hohe Oberflächenkonzentration, also z.B. eine Dotierstoffkonzentration von $10^{20}$ cm$^{-3}$. Ein damit gegebenes typisches Profil des Hauptübergangs 210 ist in Fig. 7 als Linienzug 220 dargestellt.

In einem gesonderten Diffusionsprozeß, der in der Praxis als erster Diffusionsprozeß durchgeführt wird, sind vier konzentrische $p^+$-leitende Ringe in die Hauptfläche 23 diffundiert, wovon die äußeren drei Ringe Feldringe 28 sind und der innere Ring, der sich etwas mit der $p^+$-Schicht 26 überschneidet, einen Randbereich 29 der $p^+$-Schicht bildet. In Fig. 7 ist als gestrichelter Linienzug 221 das Profil des Randbereichs 29 des pn-Übergangs dargestellt, das in gleicher Weise für die Feldringe 28 gilt. Dieses Profil 221 unterscheidet sich durch geringere Konzentration C und größere Eindringtiefe x vom Profil 220 des Hauptübergangs. In Fig. 7 sind beispielhaft Werte für die Konzentration C und die Eindringtiefe x eingetragen.

Die Stelle, an der der pn-Übergang des Randbereichs 29 an die Oberfläche 23 tritt, und auch die Feldringe 28 sind mit einer Passivierungsschicht 211 abgedeckt. Außerdem ist das Bauelement durch einen in die Oberfläche 23 diffundierten Ring vom n+-Typ, also einen sogenannten channel stopper 212 in bekannter Weise begrenzt.

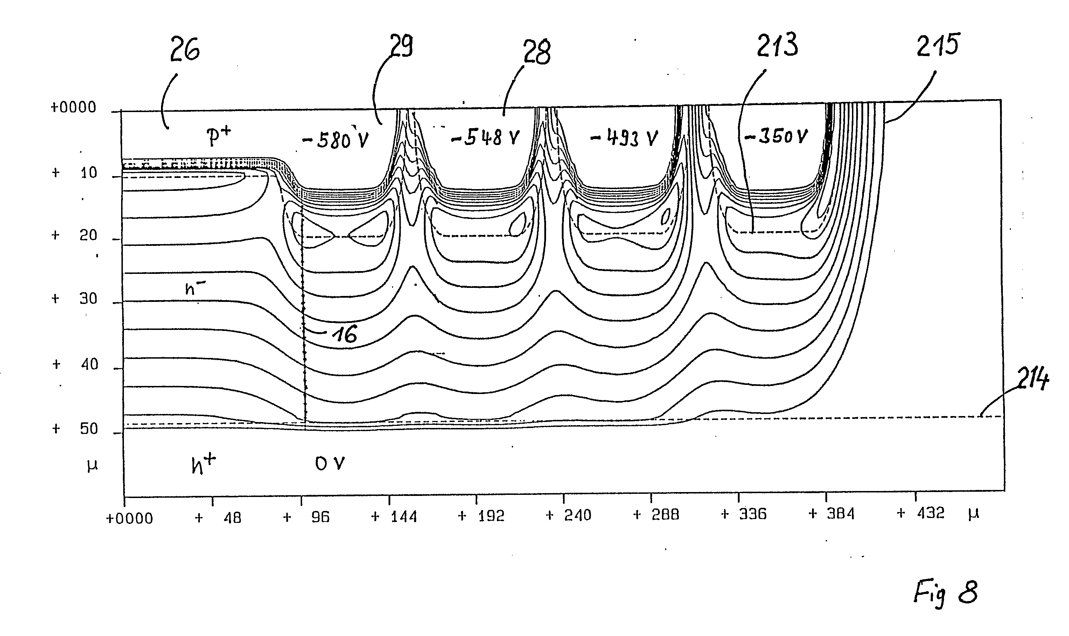

Fig. 8 zeigt das Ergebnis einer Simulationsrechnung für eine 500V-Diode, bei der bereits mit drei floatenden Ringen die Volumendurchbruchsspannung zu 100% erreicht wird. Dargestellt ist die Feldverteilung in einem Re chengebiet, das sich auf das hier interessierende Rand gebiet der Diode bezieht. Im oberen Bereich der Abbildung ist die $p^+$-leitende Schicht mit geringer Eindringtiefe zu erkennen, die übergeht in den tiefer diffundierten Randbereich 29, sowie die drei Feldringe 28. Die zugehörigen $p^+n^-$-Übergange sind im oberen Bereich der Fig. 8 durch gestrichelte Linien 213 dargestellt. Ein $n^-n^+$-Übergang ist in einem unteren Bereich als gestrichelte Linie 214 eingezeichnet. Die durchgezogenen Linien 215 verbinden Orte gleichen Feldstärkebetrages. Eine gepunktete Linie 216 zeigt den Weg höchster Beschleunigung der Ladungsträger in Richtung auf das Feldmaximum.

Hier sind die Feldmaxima an den Ringen 28 deutlich kleiner als das Maximum am Hauptübergang. Das eingezeichnete Maximum am Randbereich 29 unterscheidet sich vom Feldmaximum am Hauptübergang 26 um weniger als 1%, so daß praktisch die Volumensperrspannung erreicht ist. Damit ist nachgewiesen, daß die gestellte Aufgabe mit den vorgeschlagenen Maßnahmen gelöst werden kann.

## Ansprüche

1. Leistungshalbleiterdiode mit
- einer ersten und einer zweiten Hauptfläche,
- einer an die erste Hauptfläche angrenzenden Schicht eines p-leitenden Typs und einer an die zweite Hauptfläche angrenzenden Schicht eines n-leitenden Typs,
- eine durch Isolationsdiffusion hergestellte Zone des p-leitenden Typs, die die Diode längs ihres Randes abschließt, und
- einem pn-Übergang zwischen der n-leitenden Schicht und der Schicht sowie der Randzone des p-leitenden Typs,
dadurch gekennzeichnet, daß der pn-Übergang (10) direkt an der zweiten Hauptfläche (3) an die Oberfläche tritt und planar durch eine Passivierungsschicht (11) abgedeckt ist, daß im mittleren Bereich der Diode, der von der Isolationsdiffusion umschlossen wird, ein Dotierungsprofil vorgesehen ist, mit einem großen Gradienten der Dotierungskonzentration zwischen einem hochdotierten Bereich der p-leitenden Schicht mit einer Dotierung von $10^{16}$ bis $10^{18}$ cm$^{-3}$ und dem pn-Übergang, wobei das Diffusionsprofil in einem pn-übergangsnahen Bereich ($x$ ist nahe an $x_j$) angenähert definiert ist durch die Exponentialfunktion

$$N_x = N_0((\exp[-(x - x_j)/\text{Lambda}] - 1))$$

wobei bedeutet

$N_x$ = Dotierstoffkonzentration am Ort x,

$N_0$ = Dotierstoffkonzentration in der $n^-$-Zone,

x = Ortskoordinate, gemessen ab der ersten Hauptfläche,

$x_j$ = pn-Übergang

Lambda = Parameter der die Steilheit beschreibt und im Bereich von 0,2 bis 4 $\mu$m liegt.

2. Leistungshalbleiterdiode mit
- einer ersten und einer zweiten Hauptfläche,
- wenigstens einer ersten Schicht eines ersten Leitungstyps, z.B. n-leitenden Typs, die an die zweite Hauptfläche angrenzt, und wenigstens einer zweiten Schicht eines zweiten Leitungstyps, z.B. p-leitenden Typs,
- einem pn-Übergang zwischen der ersten und der zweiten Schicht, wobei der pn-Übergang an der ersten Hauptfläche an die Oberfläche tritt, und einem planaren Randabschluß, der durch Feldringe gebildet ist, die an die erste Hauptfläche grenzen,

dadurch gekennzeichnet, daß die Feldringe (28) und ein Randbereich (29) der zweiten Schicht (26) in einem zusätzlichen Diffusionsprozeß hergestellt sind, wobei die Dotierstoffkonzentration des Randbereichs (29) und der Feldringe (28) an der Oberfläche geringer ist als die Oberflächenkonzentration der zweiten Schicht (26) in ihrem Hauptbereich und daß für die zweite Schicht (26) ein Dotierungsprofil vorgesehen ist mit einem großen Gradienten der Dotierungskonzentration zwischen einem hochdotierten Bereich der p-leitenden Schicht mit einer Dotierung von $10^{16}$ bis $10^{18} cm^{-3}$ und dem pn-Übergang, wobei das Diffusionsprofil in einem pn-übergangsnahen Bereich (x ist nahe an $x_j$) angenähert definiert ist durch die Exponentialfunktion

$N_x = N_0 ((exp[- (x - x_j)/Lambda] - 1))$

wobei bedeutet

$N_x$ = Dotierstoffkonzentration am Ort x,

$N_0$ = Dotierstoffkonzentration in der $n^-$-Zone,

x = Ortskoordinate, gemessen ab der ersten Hauptfläche,

$x_j$ = pn-Übergang

Lambda = Parameter der die Steilheit beschreibt und im Bereich von 0,2 bis 4 μm liegt.

3. Leistungshalbleiterdiode nach Anspruch 2, dadurch gekennzeichnet, daß die Feldringe (28) und der Randbereich (29) tiefer diffundiert sind als die erste Schicht (26) in ihrem Hauptbereich.

4. Leistungshalbleiterdiode nach Anspruch 2 oder 3, dadurch gekennzeichnet, daß die Feldringe (28) sogenannte floatende Feldringe sind, die nicht durch leitende Schichten gekoppelt sind.

5. Leistungshalbleiterdiode nach einem der Ansprüche 1 bis 4, dadurch gekennzeichnet, daß als Passivierungsschicht (11,211) ein Passivierungsglas verwendet ist.

6. Leistungshalbleiterdiode nach einem der Ansprüche 1 bis 4, dadurch gekennzeichnet, daß als Passivierungsschicht (11,211) eine aus mehreren Einzelschichten zusammengesetzte Schicht vorgesehen ist.

7. Leistungshalbleiterdiode nach Anspruch 6, dadurch gekennzeichnet, daß die zusammengesetzte Schicht aus Siliziumoxid, Phosphor-Silika-Glas und Siliziumnitrid besteht und vorzugsweise durch CVD-Verfahren aufgebracht wird.

8. Leistungshalbleiterdiode nach einem der Ansprüche 1, dadurch gekennzeichnet, daß zur weiteren Verbesserung der Abschaltgeschwindigkeit eine Golddiffusion durchgeführt ist.

Fig 1

Fig 2

Fig 3

Fig 4

Fig 5

Fig 6

Fig 7

Fig 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 1, Nr. 129, Abteilung E77, 25. Oktober 1977, Seite 5850; & JP-A-52 64 883 (FUJI DENKI SEIKO K.K.) 28-05-1977 * Insgesamt * --- | 1,3-5 | H 01 L 29/91 |
| A | PATENT ABSTRACTS OF JAPAN, Band 3, Nr. 38, Abteilung E101, 30. März 1979, Seite 120; & JP-A-54 17 676 (NIPPON DENKI K.K.) 07-08-1977 * Insgesamt * --- | 2-5 | |
| A | IEEE TRANS. ON ELECTRON DEVICES, Band ED-27, Nr. 9, September 1980, Seiten 1728-1732, New York, US; R.U. MARTINELLI et al.: "The Effects of Storage Time Variations on the Forward Resistace of Silicon p+-n-n+ Diodes at Microwave Frequencies" * Zusammenfassung; Seite 1528, Zeilen 1-28 * --- | 1-2 | |

**RECHERCHIERTE SACHGEBIETE (Int. Cl.5)**

| Kategorie | Kennzeichnung des Dokuments | Betrifft Anspruch | |
|---|---|---|---|
| D,A | IEEE TRANS. ON ELECTRON DEVICES, Band ED-27, Nr. 1, 1. Januar 1980, Seiten 261-265, New York, US; T. TANAKA et al.: "Analysis of a Junction Termination Structure for Ideal Breakdown Voltage in p-n Junction Devices" * Zusammenfassung; Figur 4; Seite 264, Spalte 1, Zeilen 9-18 * --- | 1,5,7 | H 01 L 29/90 H 01 L 29/91 H 01 L 29/06 |
| A | US-A-4 485 393 (KUMAMARU et al.) * Zusammenfassung; Fig. 8D; Spalte 5, Zeilen 40-55 * ----- | 5-7 | |

Der vorliegende Recherchenbericht wurde für alle Patentansprüche erstellt

| Recherchenort | Abschlußdatum der Recherche | Prüfer |
|---|---|---|
| DEN HAAG | 12-02-1990 | MIMOUN B.J. |

EPO FORM 1503 03.82 (P0403)